# EUROPÄISCHE PATENTSCHRIFT

(11) **EP 1 224 722 B1**
(45) Veröffentlichungstag und Bekanntmachung des Hinweises auf die Patenterteilung: **04.03.2009**
(21) Anmeldenummer: 00974284.2
(22) Anmeldetag: 01.09.2000
(51) Int. Cl.: H02J 9/00, H02J 7/00

(54) **HALBLEITERSICHERUNG FÜR ELEKTRISCHE VERBRAUCHER**
SEMICONDUCTOR FUSE FOR ELECTRICAL CONSUMERS
DISPOSITIF COUPE-CIRCUIT A SEMI-CONDUCTEUR POUR CONSOMMATEURS ELECTRIQUES

(30) Priorität: 02.09.1999 DE 19941699
(43) Veröffentlichungstag der Anmeldung: 24.07.2002
(73) Patentinhaber: ROBERT BOSCH GMBH, 70442 Stuttgart (DE)
(72) Erfinder: JEHLICKA, Joerg, 71634 Ludwigsburg (DE); WAGNER, Arndt, D-71735 Eberdingen (DE)
(86) Internationale Anmeldenummer: PCT/DE2000/003030
(87) Internationale Veröffentlichungsnummer: WO 2001/017090

(56) Entgegenhaltungen:
- DE-A- 19 645 944
- US-A- 5 945 745

## Beschreibung

Die Erfindung geht aus von einer Halbleitersicherung für elektrische Verbraucher, insbesonders für elektrische Verbraucher in einem Fahrzeugbordnetz nach der Gattung des Hauptanspruchs.

### Stand der Technik

Elektrische Verbraucher, beispielsweise elektrische Verbraucher in einem Fahrzeugbordnetz, müssen durch geeignete Sicherungen oder Sicherungsschaltungen vor Überlastung geschützt werden. Solche Sicherungen sind beispielsweise als elektronische Sicherungen aufgebaut und umfassen Halbleiterschalter, die bei einer Überspannung bzw. einem Überstrom ansprechen. Bei Verbrauchern, die ständig mit Spannung versorgt werden müssen und die die Sicherung auch ständig benötigen, ist eine Sicherung erforderlich, die nur einen minimalen Ruhestrom benötigt. Beispielsweise wird für die Absicherung eines einen elektrischen Verbraucher darstellenden elektrischen Steuergeräts eines Kraftfahrzeugs eine Sicherung benötigt, die das Steuergerät dauernd absichert, auch zu Zeiten, zu denen das Fahrzeug nicht in Betrieb ist und die gesamte Energieversorgung aus der Fahrzeugbatterie erfolgen muß. Für eine solche Sicherung ist es erforderlich, daß sie nur einen geringen Ruhestrom benötigt. Noch besser wäre es, wenn sie überhaupt keinen Ruhestrom benötigen würde und damit die Batterie des Fahrzeugs auch bei längerer Standzeit nicht belasten würde.

Es ist bekannt, daß Steuergeräte in Kraftfahrzeugen über Halbleiterschalter mit der Batteriespannung versorgt werden, wobei diese Halbleiterschalter nicht nur die Spannungsversorgung übernehmen, sondern eine gewisse Absicherung gegenüber Überspannung bzw. Überstrom übernehmen. Ein Fahrzeugbordnetz, bei dem das Steuergerät über einen Halbleiterschalter aus der Fahrzeugbatterie mit Spannung versorgt wird, ist aus der DE-OS 196 45 944 bekannt. Bei diesem Fahrzeugbordnetz wird das Bordnetzsteuergerät mit Hilfe eines Feldeffekttransistors elektrisch mit der Batterie verbunden. Solange sich der Feldeffekttransistor in leitendem Zustand befindet, wird das Steuergerät mit Spannung versorgt.Wird der Feldeffekttransistor so angesteuert, daß er sperrt, geht das Steuergerät in einen "Sleep-Mode" über, in dem es nur eine sehr geringe Stromaufnahme hat und nach einer neuerlichen Ansteuerung des Feldeffekttransistors schnell wieder an Spannung gelegt und damir eingeschaltet werden kann.

### Vorteile der Erfindung

Die erfindungsgemäße Halbleitersicherung für elektrische Verbraucher mit den Merkmalen des Anpruchs 1 hat den Vorteil, daß die abzusichernden Verbraucher, beispielsweise Steuergeräte in einem Fahrzeugbordnetz, tatsächlich praktisch ruhestromfrei abgesichert werden, wobei der Anschluß und die Absicherung der Verbraucher in vorteilhafter Weise über Halbleiterschalter erfolgt. Der Vorteil von Halbleitersicherungen im Vergleich zu konventionellen Sicherungen besteht darin, daß eine Halbleitersicherung nach einer Auslösung nicht ersetzt werden muß, sondern gleich wieder betriebsbereit ist. Zudem bietet eine Halbleitersicherung den Vorteil, die Ansprechcharakteristik individuell anzupassen. Weiterhin ist eine gute Diagnostizierbarkeit gegeben und nur ein geringer mechanischer Aufwand erforderlich. Erzielt werden die Vorteile der Erfindung, indem der eigentlichen Halbleitersicherung ein ruhestromfreier Bypass mit integrierter Wakeup-Schaltung parallel geschaltet wird. Damit wird insgesamt eine ruhestromfreie Halbleitersicherung erhalten.

Weitere Vorteile der Erfindung werden durch die in den Unteransprüchen angegebenen Maßnahmen erzielt.

### Zeichnung

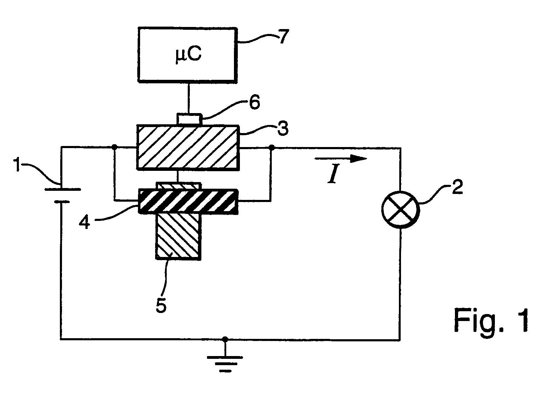

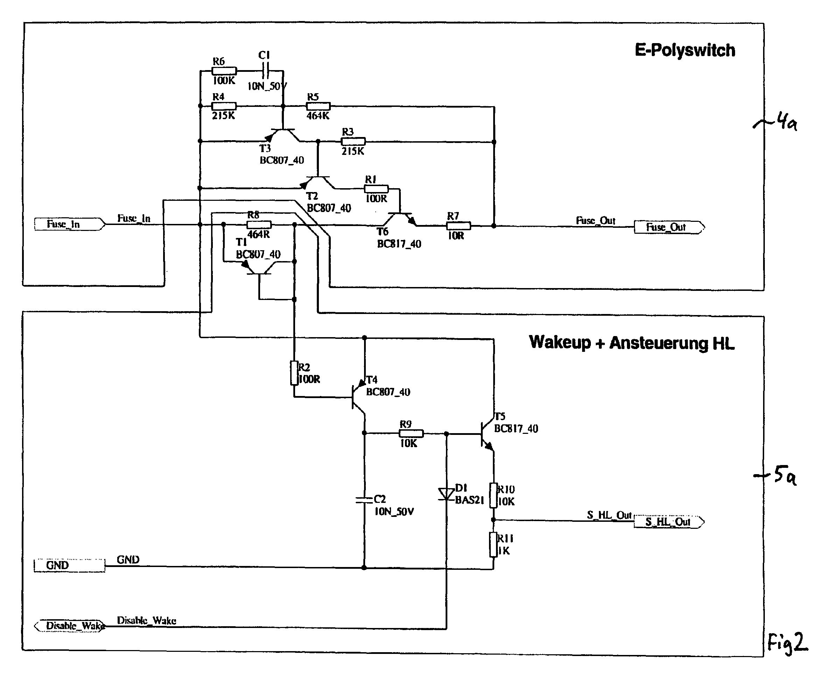

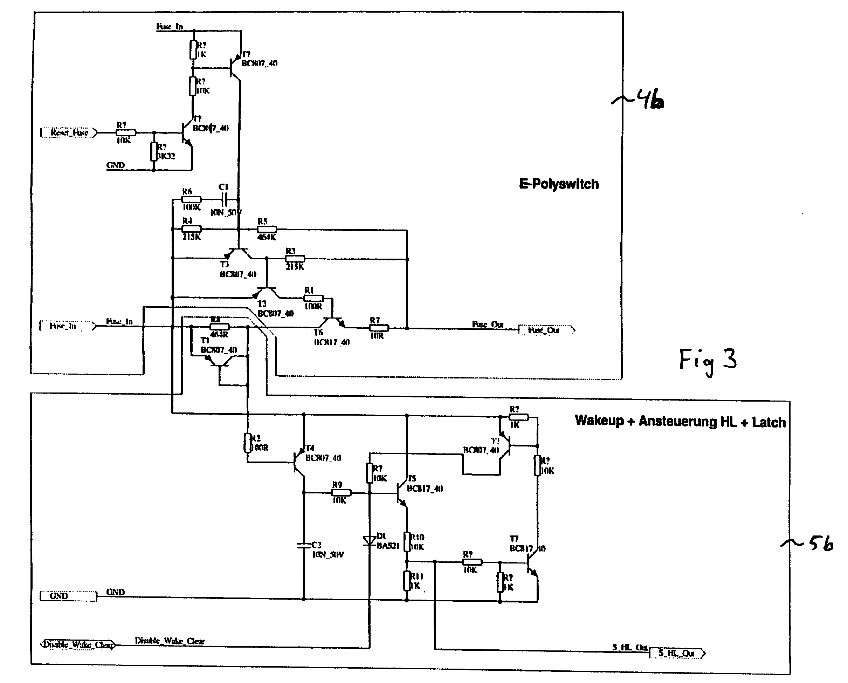

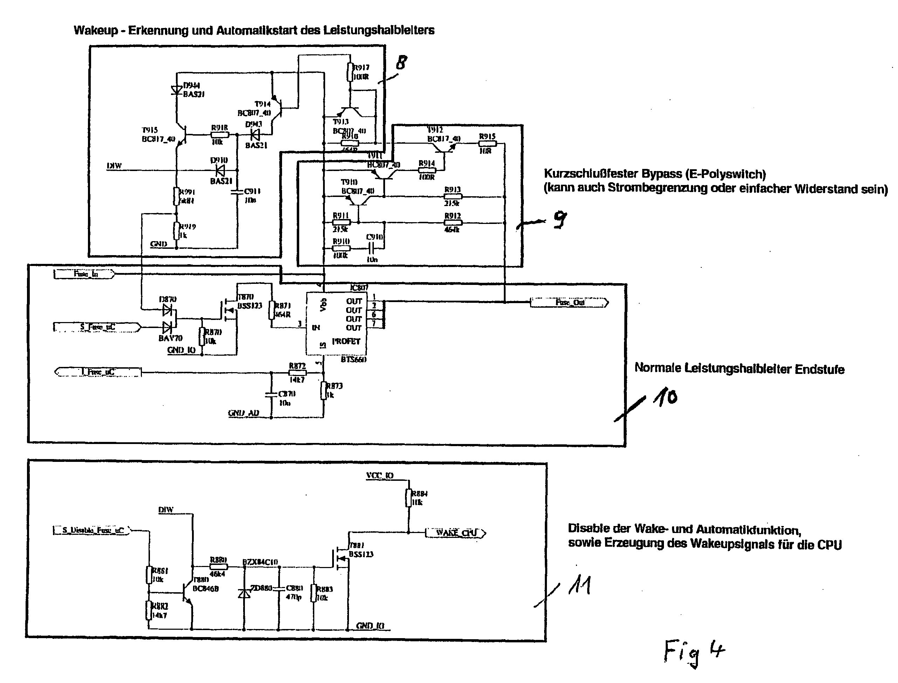

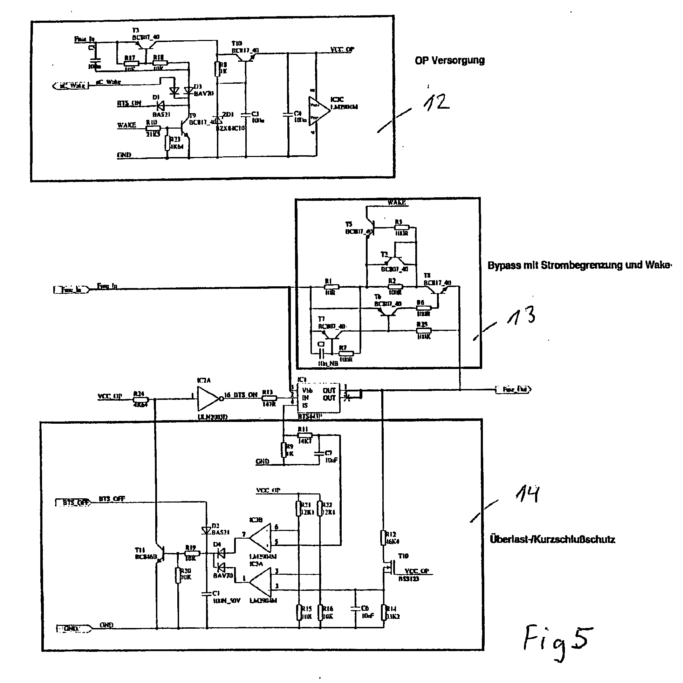

Ausführungsbeispiele der Erfindung sind in der Zeichnung dargestellt und werden in der nachfolgenden Beschreibung näher erläutert. Im einzelnen zeigt die Figur 1 ein Prinzipschaltbild eines Ausführungsbeispiels und die Figuren 2 und 3 zwei mögliche Schaltungsrealisierungen für einen kurschlußfesten Bypass und eine Wakeup-Schaltung, die in Figur 1 jeweils als Block dargestellt sind. Die Figuren 4 und 5 zeigen weitere schaltungstechnische Ausgestaltungen der Erfindung.

### Beschreibung der Ausführungsbeispiele

In Figur 1 ist ein Prinzipschaltbild eines Ausführungsbeispiels dargestellt. Dabei ist die Batterie mit 1 bezeichnet. Eine solche Batterie 1 ist beispielsweise eine 14 V- bzw. 42 V- (Ladespannung) Batterie eines Fahrzeugbordnetzes. Aus dieser Batterie soll ein Verbraucher 2, beispielsweise eine Lampe oder ein Steuergerät usw., mit Spannung versorgt werden. Diese Spannungs- bzw. Stromversorung erfolgt über einen Leistungshalbleiter 3, beispielsweise einen Smart Power Switch (BTS 660), einen kurzschlußfesten Bypass 4, z.B. einen E-Polyswitch und eine gegebenenfalls in den kurzschlußfesten Bypass 4 integrierte Wakeup-Schaltung 5. Der kurzschlußfeste Bypass 4 sowie die Wakeup-Schaltung 5 bilden in Zusammenwirkung mit dem Leistungshalbleiter 3, beispielsweise einem Feldeffekttransistor den Kern der Erfindung.

Das eigentliche Sicherungselement zu Absicherung des Verbrauchers 2 wird durch den Leistungshalbleiter 3 gebildet. Der Leistungshalbleiter 3, bzw. der Smart Power Switch, der auch für einen leistungsstarken Verbraucher mit einer Stromaufnahme von beispielsweise 5 bis 80 Ampere geeignet ist, verfügt dabei über ein Mittel zur Messung des Stromes I (Stromsense) 6. Dieses Mittel zur Messung des Stromes 6 kann beispielsweise durch eine Steuereinrichteung 7, z.B. einen Mikrocomputer ausgewertet werden und entsprechend einer im Mikrocomputer definierten Sicherungscharakteristik wird der Halbleiter 3 durch den Mikrocomputer bzw. die Steuereinrichtung 7 selbst abgeschaltet.

Wenn der Verbraucher 2 selbst keinen oder einen verschwindend geringen Strom I verbraucht, beispielsweise gilt dies für ein Steuergerät im "Sleep-Modus", oder wenn der Verbraucher 2 abgeschaltet ist, ist es nötig, den Stromverbrauch zur Ansteuerung des Halbleiters 3 ebenfalls zu senken, beispielsweise von derzeit üblichen 2 mA auf näherungsweise 0 mA, da sonst der geforderte Ruhestrom im gesamten Kraftfahrzeug nicht erreicht werden kann. Aus diesem Grund wird bei sehr geringer Stromaufnahme des Verbrauchers 2, beispielsweise bei einem Strom I von weniger als 0,5 mA, der Halbleiter 3 abgeschaltet. Der Verbraucher 2 wird dann über den kurzschlußfesten Bypass (E-Polyswitch) 4 oder eine Strombegrenzungsschaltung oder einen Widerstand versorgt. Da dieser kurzschlußfeste Bypass 4 ähnlich einem Widerstand nur in Reihe zum Verbraucher 2 geschaltet ist und keine Verbindung zur Masse erforderlich ist, verbraucht der Bypass 4 keinen Ruhestrom. Der Bypass 4 versorgt sich nur aus dem geringen Spannungsabfall von 0 bis 1,5 V, den er selbst erzeugt.

Wenn der Verbraucher 2 wieder einen höheren Strom aufnimmt, wird dies durch die mit dem Bypass 4 verbundene Wakeup-Schaltung 5 bemerkt. Diese Wakeup-Schaltung 5 kann dann den Mikrocomputer der Steuereinrichtung 7 "aufwecken" und den Halbleiter 3, beispielsweise für eine definierte Zeit, einschalten, zumindest so lange bis der Mikrocomputer wieder die Kontrolle übernimmt. Nachdem der Mikrocomputer wieder aktiv ist, übernimmt er beispielsweise die Ansteuerung des Halbleiters 3 und deaktiviert die Wakeup-Schaltung 5.

Damit im Fehlerfall, also beispielsweise bei einem Kurzschluß, keine Probleme auftreten, ist der Bypass 4 selbst kurzschlußfest aufgebaut. Er ist von seiner Charakteristik ähnlich einem Polyswitch und damit verbindet er die Vorteil der guten Leitfähigkeit im Normalfall mit der schlechten Leitfähigkeit im Überlastfall, wodurch eine Kurzschlußfestigkeit gesichert ist. Beispielsweise sind Werte realistisch von 80 mA im Normalbetrieb mit einem maximalen Spannungsabfall von ca. 1,5 V. Im Kurzschlußfall bei 42 V Spannungsabfall tritt ein Reststrom von ca. 300 A auf. Die Kurzschlußsicherung im Bypass 4 arbeitet zerstörungsfrei und ist "selbstheilend". Mit der in der Figur 1 dargestellten Schaltungsanordnung ist es möglich, eine ruhestromfreie Sicherung mit Halbleitern darzustellen.

Mögliche Realisierungen des kurzschlußfesten Bypasses 4 mit integrierter Wakeup-Funktion und Ansteuerschaltung für den Halbleiterschalter sind in den Abbildungen 2 und 3 dargestellt. In Abbildung 2 wird der kurzschlußfeste Bypass als E-Polyswitch 4a bezeichnet. Er umfaßt eine Anzahl von Widerständen, die mit R1, R3 bis R7 bezeichnet sind. Weiterhin sind die Transistoren T2, T3 und T6 sowie ein Kondensator C1 Bestandteil des kurzschlußfesten Bypasses 4 bzw. 4a, der zwischen den Anschlüssen Fuse In und Fuse Out liegt.

Die Wakeup- und Ansteuerschaltung umfaßt den Transistor T1 mit dem zwischen Kollektor und Emitter liegenden Widerstand R8. Die Transistoren T4, T5 sowie die Widerstände R2, R9 bis R11, die Diode D1 sowie der Kondensator C2 bilden die übrigen Bestandteile der Wakeup und Ansteuerschaltung 5a. Externe Anschlüsse sind Masse (GND), Disable Wake und S HL Out

Die Schaltung nach Figur 3 ist im Prinzip ähnlich aufgebaut wie die Schaltung nach Figur 2 und umfaßt neben einem E-Polyswitch 4b noch eine Wakeup und Ansteuerschaltung für den Halbleiter mit Verriegelung (latch) 5b.

Mit den Schaltungen lassen sich folgende Vorteile bzw. Eigenschaften erzielen:

Durch Dimensionierung von Widerständen und Kondensatoren, insbesonders R4 bis R6 und C1 läßt sich die Sicherungscharakteristik in weiten Grenzen einstellen. Beispielsweise kann auch ein bestimmter Strom vorgegeben werden, der mittels der Mittel zur Strommessung 6 gemessen wird und bei dessen Erreichen die Abschaltung des Leistungshalbleiters (Halbleiterschalter 3) erfolgt.

Der Spannungsabfall an der "E-Polyswitch" und der Reststrom im Kurzschlußfall sind gering.

Die Schaltung braucht keinen eigenen Betriebsstrom, sie ist somit ruhestromfrei.

Die Wakeup-Schaltung läßt sich gut ohne zusätzlichen Spannungsabfall in die E-Sicherung integrieren.

Die Schaltung ist mit einfachen Standardbauteilen aufgebaut und damit kostengünstig herstellbar.

Für den Leistungsstrom kann ein externer Leistungshalbleiter 3, beispielsweise ein Leistungshalbleiter mit der Bezeichnung BTSxxx verwendet werden, der bereits kostengünstig erhältlich ist.

Zusätzliche Funktionen wie Disable der Wake- und Ansteuerungsfunktion sowie eine Latch-Charakteristik der Ansteuerung des Halbleiters ist leicht zu integrieren, dies gilt insbesonders für eine Schaltungsanordnung nach Abbildung 3.

Beide Schaltungen funktionieren über einen großen Temperaturbereich von -40°C bis 80°C hinreichend genau.

Wenn die abzusichernden Ströme, beispielsweise unter 500 mA bleiben, kann der kurzschlußfeste Bypass 4 (E-Polyswitch) auch selbst als ruhestromfreie Sicherung betrieben werden. In diesem Fall kann die Wakeup-Schaltung und die Ansteuerschaltung für den Halbleiter entfallen. Je nach Erfordernis und Funktionswünschen können zusätzliche Varianten mit mehr oder weniger aufwendigem Aufbau dargestellt werden.

In den Figuren 4 und 5 sind weitere schaltungstechnische Ausgestaltungen der Erfindung dargestellt. Dabei ist jeweils das Zusammenwirken einzelner Schaltungsblöcke verdeutlicht.

In Figur 4 ist das Zusammenwirken einer Schaltung 8 zur Wakeup-Erkennung und zum Automatikstart des Leistungshalbleiters mit dem kurzschlußfesten Bypaß (E-Polyswitch) 9 und der Leistungshalbleiter-Endstufe 10 dargestellt. Die Erzeugung des Wakeupsignals sowie die Sperrung der Weck- und Automatikfunktion erfolgt im Schaltungsteil 11.

In Figur 5 ist eine mögliche Schaltung zur Versorgung eines Operationsverstärkers mit 12 bezeichnet. Die Spannung VCC OP dient in nicht näher dargestellter Weise zur Versorgung der eingesetzten Verstärker Der Bypaß mit Strombegrenzung und Wakeup 13 arbeitet mit der Schaltung zum Überlast- und Kurzschlußschutz 14 zusammen.

## Patentansprüche

1. Halbleitersicherung für elektrische Verbraucher (2), die von einer Strom- oder Spannungsquelle (1) mit elektrischer Leistung versorgt werden, mit einem Halbleiterschalter (3) insbesonders einem Leistungshalbleiter zwischen der Strom- oder Spannungsquelle und dem Verbraucher über den der Verbraucher zu- oder abschaltbar ist, wodurch die Stromversorgung des Verbrauchers und dessen Schutz bei Überspannung oder Überstrom gewährleistet ist, mit wenigstens einer Wakeup-Schaltung (5) und einer externen Steuereinrichtung (7) mit einem Mikrocomputer, die mit dem Halbleiterschalter zusammenwirkt, **dadurch gekennzeichnet, dass** parallel zum Halbleiterschalter (3) ein kurzschlußfester Bypass (4) liegt, der als Schaltung aufgebaut ist, die gute Leitfähigkeit im Normalfall und schlechte Leitfähigkeit im Überlastfall aufweist und in ausgeschaltetem Zustand keinen Strom benötigt, dass dem kurzschlußfester Bypass (4) die Wakeup-Schaltung (5) zugeordnet ist, die mit dem Halbleiterschalter (3) zusammenwirkt und ihn für eine bestimmte Zeit einschaltet, wenn der Verbraucher (2) wieder einen höheren Strom aufnimmt und dass der Halbleiterschalter (3) und/oder der kurzschlußfeste Bypass (4) und/oder die Wakeup-Schaltung (5) von der externen Steuereinrichtung (7) mit einem Mikrocomputer oder dem Steuergerät einer Brennkraftmaschine ansteuerbar sind,

2. Halbleitersicherung für elektrische Verbraucher nach Anspruch 1, **dadurch gekennzeichnet, dass** der Halbleiterschalter (3) Mittel zur Strommessung (6) umfaßt, die mit mit der Steuereinrichtung (7) in Verbindung stehen und dass die Steuereinrichtung (7) den Halbleiterschalter (3) abschaltet, sofern der ermittelte Strom einen vorgebbaren Wert unterschreitet oder überschreitet.

## Claims

1. Semiconductor fuse for electrical loads (2) which are supplied with electrical power by a current or voltage source (1), having a semiconductor switch (3), in particular a power semiconductor, between the current or voltage source and the load, which switch can be used to connect or disconnect the load, thus ensuring that the load is supplied with current and is protected in the event of an overvoltage or overcurrent, having at least one wake-up circuit (5) and an external control device (7) with a microcomputer, which interacts with the semiconductor switch, **characterized in that** a bypass (4) which is resistant to short circuits is in parallel with the semiconductor switch (3) and is in the form of a circuit which has good conductivity in the normal case and poor conductivity in the event of an overload and does not require any current when switched off, **in that** the bypass (4) which is resistant to short circuits is assigned the wake-up circuit (5) which interacts with the semiconductor switch (3) and switches on the latter for a particular amount of time if the load (2) consumes a higher amount of current again, and **in that** the semiconductor switch (3) and/or the bypass (4) which is resistant to short circuits and/or the wake-up circuit (5) can be driven by the external control device (7) with a microcomputer or the controller of an internal combustion engine.

2. Semiconductor fuse for electrical loads according to Claim 1, **characterized in that** the semiconductor switch (3) comprises means which are intended to measure the current (6) and are connected to the control device (7), and **in that** the control device (7) switches off the semiconductor switch (3) if the current determined undershoots or exceeds a predefinable value.

## Revendications

1. Protection à semi-conducteur pour consommateurs électriques (2) alimentés en énergie électrique par une source de courant ou de tension (1), laquelle protection présente entre la source de courant ou de tension et le consommateur un commutateur à semi-conducteur (3), en particulier à semi-conducteur de puissance, par lequel le consommateur peut être branché ou débranché, ce qui assure l'alimentation en courant du consommateur et sa protection en cas de surtension ou de surcourant,
et présente un circuit d'éveil (5) et un dispositif externe de commande (7) doté d'un micro-ordinateur qui coopère avec le commutateur à semi-conducteur,
**caractérisé en ce que**
une dérivation (4) résistant aux courts-circuits, constituée d'un circuit qui présente une bonne conductivité à l'état normal et une mauvaise conductivité en cas de surcharge et qui ne nécessite aucun courant à l'état débranché est placée en parallèle au commutateur (3) à semi-conducteur,
**en ce que** le circuit d'éveil (5) qui coopère avec le commutateur (3) à semi-conducteur et qui le branche pendant une durée définie lorsque le consommateur (2) reprend de nouveau un courant trop élevé est associé à la dérivation (4) résistant aux courts-circuits et
**en ce que** le commutateur (3) à semi-conducteur et/ou la dérivation (4) résistant aux courts-circuits et/ou le circuit d'éveil (5) peuvent être commandé par le dispositif externe de commande (7) à micro-ordinateur ou par l'appareil de commande d'un moteur à combustion interne.

2. Protection à semi-conducteur pour consommateur électrique selon la revendication 1, **caractérisée en ce que** le commutateur (3) à semi-conducteur présente des moyens de mesure de courant (6) qui sont reliés au dispositif de commande (7) et **en ce que** le dispositif de commande (7) débranche le commutateur (3) à semi-conducteur lorsque le courant déterminé n'atteint pas ou dépasse une valeur prédéterminée.
